# EUROPEAN PATENT APPLICATION

(11) **EP 2 613 199 A1**
(43) Date of publication of application: **10.07.2013**
(21) Application number: 11821952.6
(22) Date of filing: 02.09.2011
(51) Int. Cl.: G03F 7/42, C11D 7/26, C11D 7/50, H01L 21/027, H01L 21/304

(54) **PHOTORESIST RESIDUE AND POLYMER RESIDUE REMOVING LIQUID COMPOSITION**

(30) Priority: 03.09.2010 JP 2010198302
(71) Applicant: Kanto Kagaku Kabushiki Kaisha, Tokyo 103-0023 (JP)
(72) Inventor: OHWADA, Takuo, Soka-shi Saitama 340-0003 (JP)
(74) Representative: Zech, Stefan Markus
(86) International application number: PCT/JP2011/069992
(87) International publication number: WO 2012/029938

(57) **Abstract**

Provided are a photoresist residue and polymer residue removing liquid composition, and a method of removing the residue used therewith, for removing photoresist residue and polymer residue produced during a process of manufacturing a semiconductor circuit element having metallic wiring. Specifically, the composition does not contain nitrogen-containing organic hydroxyl compounds, ammonia or fluorine compounds, and contains an aliphatic polycarboxylic acid having a melting point of 25°C or higher with an excellent residue removing property and having a metallic oxide main component as the residue removing component. The photoresist residue and polymer residue removing liquid composition, and the method of removing the residue used therewith, is capable of preventing the aliphatic polycarboxylic acid from being recrystallized by evaporation of water after a solution has adhered around a cleaning device liquid ejecting nozzle or a cleaning tank and a chamber. In the photoresist residue and polymer residue removing liquid composition containing the aliphatic polycarboxylic acid with a melting point of 25°C or higher, the removing liquid contains an organic solvent that is miscible with water and has a vapor pressure of 17 mm Hg or less at 25°C and a hydroxyl group within the structure.

## Description

### [Technical Field]

The present invention relates to a composition for removing photoresist residue and polymer residue remaining after dry etching and after ashing in a production process for a semiconductor circuit element having metal wiring, and a method for removing residue employing same.

### [Background Art]

In recent years, semiconductor circuit elements have been increasingly progressing toward microfabrication and high integration; accompanying this, microfabrication of the element structure is required, and new wiring materials and interlayer insulating film materials have been employed. As wiring materials, copper and a copper alloy containing copper as a main component are used, and as interlayer insulating film materials, organic materials represented by an aryl ether compound having lower permittivity (low-k) and a SiOCH₃-based material having a methyl group (-CH₃) introduced into a silicon oxide film are used. Furthermore, with regard to low-k materials, for the purpose of achieving lower permittivity, porosification of a material has been carried out. Because of this, when patterning these novel materials by dry etching, since the conditions for dry etching and ashing are different, the constitution of photoresist residue and polymer residue is naturally also different. Furthermore, copper and a copper alloy have low resistance to oxidation, and low-k materials are also brittle materials having low chemical and physical strength compared with a silicon oxide film.

As a photoresist residue and polymer residue remover, for example, in the case in which the wiring is aluminum or an aluminum alloy, a composition containing "a fluorine compound + a quaternary ammonium compound + water + an organic solvent" (Patent Document 1) and a composition containing "hydroxylamine + an alkanolamine (+ an organic solvent)" (Patent Document 2) have been proposed. Although these compositions can minimize corrosion of the aluminum or aluminum alloy and remove photoresist residue and polymer residue, they are not compatible with copper, a copper alloy, or a low-k material, and the residue removability might be insufficient or these materials might be attacked.

On the other hand, in the case in which the wiring is copper or a copper alloy and the interlayer insulating film is a low-k material, a composition containing "one or more types of fluorine compound + one or more types of glyoxylic acid, etc. + water" (Patent Document 3) and a composition containing "ammonium fluoride + a water-soluble organic solvent + a buffer + water + a basic compound" (Patent Document 4) have been proposed. However, since these compositions contain a fluorine compound, when a SiOCH₃-based low-k is processed by dry etching, a degenerated layer similar to a porous silicon oxide film is formed on a SiOCH₃ surface formed during dry etching and ashing. Since a composition containing a fluorine compound will dissolve the degenerated layer, there is a possibility that the actual etching dimensions will be larger than the intended etching dimensions.

As a composition containing no fluorine compound, a composition mainly containing an organic acid such as a carboxylic acid has been proposed. As the composition containing an organic acid, a composition containing "an aliphatic polycarboxylic acid and/or a salt thereof (+ an aminopolycarboxylic acid) + water but containing no organic solvent" (Patent Document 5) and a composition containing "an aliphatic polycarboxylic acid + a reducing compound such as glyoxylic acid + water" (Patent Document 6) have been proposed.

Furthermore, a composition containing "a carboxylic acid + a water-soluble organic solvent + water" (Patent Document 7), a composition containing "an organic acid and/or a salt thereof + water + an organic solvent" (Patent Document 8), a composition containing "an organic acid or a salt thereof + water (+ an organic solvent)" (Patent Document 9), a composition containing "a monocarboxylic acid + water (+ an organic solvent + a polycarboxylic acid)" (Patent Document 10), etc. have also been proposed.

Moreover, a composition containing "a nitrogen-containing organic hydroxy compound + a carboxyl group-containing organic compound that contains no hydroxy group in the molecule" (Patent Document 11) and a composition containing "an ammonium polycarboxylate salt or an ammonium aminopolycarboxylate salt + a water-soluble organic solvent + water" (Patent Document 12) have been proposed.

However, in all of the above-mentioned conventional techniques, a residue remover composition for removing photoresist residue and polymer residue formed during an ashing treatment of a photoresist after processing by dry etching is applied to batch type cleaning (a method in which cleaning is carried out by immersing a plurality of materials to be cleaned at the same time), but due to concerns about transfer or carry-over of contaminants in batch type cleaning, a single wafer cleaning method has been attracting attention in recent years.
With regard to an example of the single wafer cleaning method, although the intended application is different, as a cleaning liquid composition for removing effectively various types of metal-derived impurities (metallic impurities) or microparticles (particles) present on a substrate surface, a composition containing "a carboxyl group-containing organic acid + an organic solvent" (Patent Document 13), and as a cleaning liquid having a high ability to remove particles from a hydrophobic surface such as bare silicon or a low-k material, a composition containing "an aliphatic polycarboxylic acid + a hydroxy group- and/or ether group-containing organic solvent" (Patent Document 14) have been proposed.

Furthermore, a residue remover composition containing a fluorine compound that can be used in single wafer cleaning has been proposed (Patent Document 16), but it cannot be said that it is adequate for application to a semiconductor circuit element having metal wiring.
As described above, in the current situation there has not yet been obtained a photoresist residue and polymer residue remover composition that is fully satisfactory and suitable for single wafer cleaning where it is essential to carry out the treatment at low temperature for a short period of time without metal wiring or an interlayer insulating film being attacked.

### [Prior Art Documents]

### [Patent Documents]

[Patent Document 1] JP, A, 7-201794
[Patent Document 2] US Pat. No. 5334332
[Patent Document 3] JP, A, 2003-280219
[Patent Document 4] JP, A, 2003-241400
[Patent Document 5] JP, A, 11-316464
[Patent Document 6] JP, A, 2003-167360
[Patent Document 7] JP, A, 10-256210
[Patent Document 8] JP, A, 2000-206709
[Patent Document 9] JP, A, 2002-75993
[Patent Document 10] JP, A, 11-67703
[Patent Document 11] JP, A, 7-219240
[Patent Document 12] JP, A, 2001-242641
[Patent Document 13] WO 2005-040324
[Patent Document 14] JP, A, 2004-307725
[Patent Document 15] JP, A, 2008-107494

### [Summary of the Invention]

### [Problems to be Solved by the Invention]

The present inventors have noticed that in order to remove by single wafer cleaning, where it is essential to carry out the treatment at room temperature for short time without attacking various types of metal wiring or interlayer insulating films, photoresist residue and polymer residue having various compositions remaining after forming various types of metal wiring, such as aluminum, copper, or alloys thereof, that have been introduced in recent years, an aliphatic polycarboxylic acid, which has an effect in dissolving the oxide of a metal such as aluminum or copper without dissolving aluminum, copper, or alloys thereof, which are the main components of polymer residue, is very effective.
However, these aliphatic polycarboxylic acids have a high melting point and are solid at room temperature, and when used in a single wafer cleaning system, if discharged liquid is left attached to a discharge nozzle or scattered in a chamber, the water evaporates, and the aliphatic polycarboxylic acid dissolved therein recrystallizes, and these crystals become attached to a cleaned wafer surface, thus causing back-contamination, which is a problem that has to be tackled.

Therefore, an object of the present invention is to solve the above-mentioned new problems and to provide a photoresist residue and polymer residue remover composition that removes, by single wafer cleaning, photoresist residue and polymer residue formed during a production process for a semiconductor circuit element having metal wiring, and a method for removing residue using same.

### [Means for Solving the Problems]

While carrying out an intensive investigation in order to solve the above-mentioned problems, the present inventors have found that by combining an aliphatic polycarboxylic acid having a high melting point with a specific compound it is possible to suppress recrystallization without changing the ability of the aliphatic polycarboxylic acid to remove residue, thus suppressing back-contamination of a wafer by recrystallized material and improving the working efficiency in a step of removing photoresist residue and polymer in a semiconductor production process, and as a result of further research, the present invention has been accomplished.

That is, the present invention relates to the following composition for removing residue by single wafer cleaning and method for removing residue using same.
[1]
   A composition for removing photoresist and/or polymer residue by single wafer cleaning, the composition comprising an aliphatic polycarboxylic acid having a melting point of at least 25°C and an organic solvent having a hydroxy group and a vapor pressure at 20°C of no greater than 17 mmHg.
[2]
   The composition according to [1], wherein it comprises water.
[3]
   The composition according to [1] or [2], wherein the organic solvent is one or more types selected from the group consisting of a monohydric to trihydric aliphatic alcohol, a compound in which one or two hydroxy groups of glycerol are replaced by an alkoxy group, a tetrahydrofurfuryl alcohol, a monoalkylene glycol monoalkyl ether, a polyalkylene glycol, and a polyalkylene glycol monoalkyl ether.
[4]
   The composition according to any one of [1] to [3], wherein the organic solvent is miscible with water.
[5]
   The composition according to any one of [1] to [4], wherein the content of the organic solvent is at least 30 vol%.
[6]
   The composition according to any one of [1] to [5], wherein the aliphatic polycarboxylic acid is oxalic acid.
[7]
   A method for removing photoresist and/or polymer residue by single wafer cleaning by use of the composition according to any one of [1] to [6].

### [Effects of the Invention]

In accordance with the present invention, by combining an aliphatic polycarboxylic acid having a high melting point with an organic solvent having a hydroxy group and a vapor pressure at 20°C of no greater than 17 mmHg, it becomes possible to suppress recrystallization of the aliphatic polycarboxylic acid due to evaporation of water on a liquid discharge nozzle or the area around a cleaning bath and a chamber of a cleaning system without changing the basic characteristics of the aliphatic polycarboxylic acid such as photoresist residue removability, polymer residue removability, and damage to the materials, and it is possible to suppress back-contamination of a wafer by recrystallized material and improve the working efficiency in a step of removing photoresist residue and polymer residue in a semiconductor production process.

Since the photoresist residue and polymer residue remover composition of the present invention contains an aliphatic polycarboxylic acid, it has high solubility toward aluminum oxide-containing polymer residue remaining after aluminum or aluminum alloy wiring is formed and copper oxide-containing polymer remaining on a copper or copper alloy surface at a via hole bottom or the via hole side wall surrounding it after a via hole is formed, and it causes hardly any corrosion of aluminum or aluminum alloy and copper or copper alloy wiring material. It is surmised that, since the ability to form a complex between an aliphatic polycarboxylic acid and an ion of the above metals is high, the removability for metal oxide-containing polymer residue is high and, in addition, since, unlike nitric acid, hydrogen peroxide, etc., an aliphatic polycarboxylic acid does not have oxidizing power, the wiring material metal itself is not ionized, and the wiring material is not corroded.

Furthermore, with regard to the photoresist residue and polymer residue remover composition of the present invention, since the melting point of the aliphatic polycarboxylic acid used is at least 25°C, it does not evaporate at around room temperature, variation in the constitution of the composition when it is reused is small, there is no characteristic organic acid odor, and the work environment can be maintained well.

When an aliphatic polycarboxylic acid having a melting point of at least 25°C as described above is used as a solution in water, due to evaporation of water, which has a high vapor pressure and is easily evaporated, the aliphatic polycarboxylic acid undergoes recrystallization and precipitation. Therefore, when these compositions are used in a cleaning system, they become attached to a nozzle for discharging the composition, the edge of a cleaning bath, and scattered on the area around a chamber, and a wafer during and after cleaning is back-contaminated, thus causing a decrease in the device production yield. Because of this, it is necessary to clean the nozzle, the cleaning bath, and the chamber at predetermined intervals, thus lowering the work efficiency.

Since the photoresist residue and polymer residue remover composition of the present invention contains a solvent having high solubility for an aliphatic polycarboxylic acid and having a vapor pressure of no greater than 17 mmHg at 20°C, which is lower than that of water (17.536 mmHg (20°C), reference "Yozai Handobukku" (Solvent Handbook)), when it is left in the atmosphere the solvent does not evaporate, and it is possible to prevent recrystallization and precipitation of the aliphatic polycarboxylic acid.
Furthermore, it has also been found that since the organic solvent in the photoresist residue and polymer residue remover composition of the present invention has a hydroxy group in its structure, the solubility for an aliphatic polycarboxylic acid improves, and there is an effect in suppressing further precipitation. Moreover, these organic solvents do not greatly affect the photoresist residue and polymer residue removability or the corrosivity toward the materials.

### [Brief Description of Drawings]

[FIG. 1] FIG. 1 is a diagram showing the amount of oxalic acid dissolved in a solution when the ratio by volume of organic solvent and water is changed.
[FIG. 2] FIG. 2 is a diagram showing the effect of organic solvent in suppressing precipitation of crystals.

### [Modes for Carrying Out the Invention]

Modes for carrying out the present invention are explained below.
In the specification of the present application, with regard to a production process for a semiconductor circuit element having metal wiring, the photoresist and/or polymer residue remover composition is used in order to remove, by single wafer cleaning, photoresist residue and polymer residue remaining on the semiconductor substrate after carrying out dry etching with a photoresist as a mask and further carrying out ashing, or on the semiconductor substrate after carrying out dry etching with an inorganic material as a mask, and contains an aliphatic polycarboxylic acid having a melting point of at least 25°C and an organic solvent having a hydroxy group and a vapor pressure at 20°C of no greater than 17 mmHg.

In the present invention, the "photoresist residue" and the "polymer residue" mean photoresist residue after forming metal wiring and polymer residue containing an oxide or halide of a metal such as copper, aluminum, titanium, tantalum, tungsten, germanium, antimony, or tellurium.
In the present invention, the "single wafer cleaning" referred to is a cleaning method in which, while spinning a substrate, a residue remover composition is sprayed onto the substrate surface via a nozzle. Although it is possible to employ, in combination with the above, physical cleaning such as brush scrubber cleaning by means of a sponge brush or megasonic cleaning using high frequency waves, from the viewpoint of preventing any damage to a pattern formed on the substrate, it is preferable not to use a physical action in combination.

Examples of the aliphatic polycarboxylic acid having a melting point of at least 25°C used in the photoresist residue and polymer residue remover composition of the present invention include oxalic acid, citric acid, malonic acid, tartaric acid, succinic acid, and malic acid. Among them, oxalic acid is preferable since it has a simple molecular structure and has a high complex stability constant with various types of metal oxides. Since oxalic acid has a high complex stability constant with copper oxide, it has excellent removability for polymer residue containing copper oxide. Furthermore, since it has the simplest structure among dicarboxylic acids, has a low molecular weight, and exhibits a high effect with a low content, compared with other organic acids, the total organic carbon (TOC), the biochemical oxygen demand (BOD), and the chemical oxygen demand (COD) in effluent are small, and the load on effluent treatment is low.

The content of the aliphatic polycarboxylic acid is not particularly limited, but from the viewpoint of removability for photoresist residue and polymer residue, it is preferably 0.3 to 10.0 vol%, and more preferably 3.0 to 5.0 vol%.

Furthermore, the organic solvent having a hydroxy group and having a vapor pressure at 20°C of no greater than 17 mmHg used in the photoresist residue and polymer residue remover composition of the present invention is preferably miscible with water.

Specific examples thereof include monohydric aliphatic alcohols such as 1-butanol, 2-methyl-2-propanol, and diacetone alcohol; other monohydric alcohols such as diacetone alcohol, furfuryl alcohol, and tetrahydrofurfuryl alcohol; dihydric aliphatic alcohols such as 1,2-ethanediol, 1,2-propanediol, 1,3-propanediol, 1,3-butanediol, 1,4-butanediol, 2,3-butanediol, and 1,5-pentanediol, which are monoalkylene glycols; trihydric aliphatic alcohols such as glycerol; compounds formed by substituting one or two hydroxy groups of glycerol with an alkoxy group, such as 3-methoxy-1,2-propanediol and 1,3-dimethoxy-2-propanol;

monoalkylene glycol monoalkyl ethers such as propylene glycol monomethyl ether, propylene glycol monoethyl ether, propylene glycol monopropyl ether, and propylene glycol n-butyl ether; polyalkylene glycols such as diethylene glycol, dipropylene glycol, triethylene glycol, and tripropylene glycol; and polyalkylene glycol monoalkyl ethers such as diethylene glycol monomethyl ether, diethylene glycol monoethyl ether, diethylene glycol n-butyl ether, dipropylene glycol monomethyl ether, dipropylene glycol monoethyl ether, triethylene glycol monomethyl ether, triethylene glycol monoethyl ether, tripropylene glycol monomethyl ether, tripropylene glycol monoethyl ether, and tetraethylene glycol.

Among them, 1,2-ethanediol, 1,2-propanediol, 1,3-propanediol, 1,3-butanediol, 1,4-butanediol, glycerol, diethylene glycol, dipropylene glycol, triethylene glycol, tripropylene glycol, diethylene glycol monomethyl ether, diethylene glycol monoethyl ether, diethylene glycol n-butyl ether, dipropylene glycol monomethyl ether, dipropylene glycol monoethyl ether, triethylene glycol monomethyl ether, triethylene glycol monoethyl ether, tripropylene glycol monomethyl ether, tripropylene glycol monoethyl ether, and tetrahydrofurfuryl alcohol, which are relatively easy to obtain, are inexpensive, and have little effect on the human body, are preferable and among them, from the viewpoint of improving the solubility of the aliphatic polycarboxylic acid, aliphatic alcohols, and 1,2-ethanediol, 1,2-propanediol, glycerol, diethylene glycol, dipropylene glycol, diethylene glycol monomethyl ether, dipropylene glycol monomethyl ether, and tetrahydrofurfuryl alcohol, which are aliphatic glycols or derivatives thereof, are particularly preferable.

The photoresist residue and polymer residue remover composition of the present invention may contain a single type of the above organic solvent or two or more types in combination.
The content of the organic solvent is not particularly limited; it is determined appropriately according to the removability for photoresist residue and polymer residue and the corrosivity toward the above-mentioned metal or interlayer insulating film while taking into consideration the content of other components, and it is preferably at least 30.0 vol%, and more preferably at least 50.0 vol%. When the content is too low, water easily evaporates, and the solubility for an aliphatic polycarboxylic acid does not improve. Furthermore, when the content is too high, the viscosity becomes too high, there is a possibility that it will fall under the category of hazardous materials having a flash point, and handling will become difficult.

Furthermore, the photoresist residue and polymer residue remover composition of the present invention may contain water. Accompanying an increase in the water content, dissociation of the aliphatic polycarboxylic acid progresses, the solubility of a complex compound with a metal improves, and the removability for photoresist residue and polymer residue is generally increased. However, in order to prevent recrystallization of the aliphatic polycarboxylic acid, it is necessary for there to be a certain level of water and the organic solvent that has a hydroxy group in the structure, has a vapor pressure at 20°C of no greater than 17 mmHg, and is miscible with water. Therefore, the water content is 0 to 80.0 vol%, preferably 20.0 to 70.0 vol%, and more preferably 30.0 to 60.0 vol%.

On the other hand, with regard to a fluorine compound, which is widely used as a component of a photoresist residue and/or polymer residue remover composition, from the viewpoint of high reactivity with a metal oxide, which is a main component of residue, the ability to reduce the treatment time down to a range that can be used in a single wafer cleaning system, and the ability to dissolve silicon oxide, a fluorine compound may be contained, but since it dissolves a degenerated layer, formed by dry etching or ashing, of a brittle low-k material, which is used as an interlayer insulating film, there is a possibility that the actual etching dimensions will be larger than the intended etching dimensions, and with recent developments in microfabrication of semiconductor elements, the electrical characteristics of an element might be greatly affected by a dimensional change that had conventionally been acceptable. Therefore, depending on the mode in which the photoresist residue and/or polymer residue remover composition of the present invention is used, it is sometimes preferable for a fluorine compound not to be contained.

Furthermore, in order to prevent corrosion of copper or a copper alloy, in some cases it is preferable for the photoresist residue and/or polymer residue remover composition of the present invention not to contain a nitrogen-containing organic hydroxy compound and/or ammonia, depending on the mode in which it is used.

The photoresist residue and/or polymer residue remover composition of the present invention may be applied to a semiconductor substrate that has silicon, a silicon oxide film, a silicon nitride film, or a silicon oxide nitride film used as a transistor portion, a hafnium-based material, which is a high permittivity material, as a gate insulating film, and a material such as titanium, tantalum, tungsten, or ruthenium as a gate electrode.

Furthermore, the photoresist residue and/or polymer residue remover composition of the present invention may also be applied to a semiconductor substrate having an alloy of germanium, antimony, and selenium, which is a material whose resistance is changed by crystallization by heating and amorphization by cooling, used in a phase-change memory, which has been developed as a nonvolatile memory device.

### [Examples]

With regard to the photoresist residue and polymer residue remover composition of the present invention, the present invention is now explained in further detail by reference to Examples and Comparative Examples, but the present invention is not limited by these Examples.

### <Evaluation 1: Evaluation of solubility of aliphatic carboxylic acid>

Oxalic acid (anhydrous) (20 g) was added to each solution (100 mL), and it was sealed and allowed to stand for at least 12 hours while stirring. Subsequently, the supernatant was diluted by 100 times, the absorbance at 255 nm was measured by a spectrophotometer, and the solubility of oxalic acid was determined.
Table 1 shows the amount of oxalic acid dissolved in each solution.

[Table 1]

**Table 1. Amount of oxalic acid dissolved in each solution**

| Organic solvent | | Organic solvent/water (ratio by volume) | Amount of Oxalic acid dissolved (g/L) |
|---|---|---|---|
| Ex. 1 | 2-Methyl-2-propanol | 50/50 | 144.0 |
| Ex. 2 | Ethylene glycol | 50/50 | 155.6 |
| Ex. 3 | Propylene glycol | 50/50 | 152.1 |
| Ex. 4 | Glycerol | 50/50 | 148.1 |
| Ex. 5 | Dipropylene glycol | 50/50 | 144.4 |
| Ex. 6 | Dipropylene glycol monoethyl ether | 50/50 | 114.1 |
| Ex. 7 | Tripropylene glycol monomethyl ether | 50/50 | 121.0 |
| Ex. 8 | Tetrahydrofurfuryl alcohol | 50/50 | 154.6 |
| Ex. 9 | Propylene glycol | 10/90 | 102.6 |
| Ex. 10 | Propylene glycol | 30/70 | 118.1 |
| Ex. 11 | Propylene glycol | 70/30 | 201.5 |
| Ex. 12 | Glycerol | 10/90 | 102.3 |
| Ex. 13 | Glycerol | 30/70 | 115.1 |
| Ex. 14 | Glycerol | 70/30 | 198.5 |
| Ex. 15 | Tripropylene glycol monomethyl ether | 10/90 | 102.5 |
| Ex. 16 | Tripropylene glycol monomethyl ether | 30/70 | 115.1 |
| Ex. 17 | Tripropylene glycol monomethyl ether | 70/30 | 198.5 |
| Comp. Ex. 1. | Phosphoric acid (comparative) | 10/90 | 72.4 |
| Comp. Ex. 2 | Phosphoric acid (comparative) | 30/70 | 33.4 |
| Comp. Ex. 3 | Phosphoric acid (comparative) | 50/50 | 17.8 |
| Comp. Ex. 4 | Phosphoric acid (comparative) | 70/30 | 17.7 |
| Comp. Ex. 5 | None (comparative, water only) | 0/100 | 102.2 |

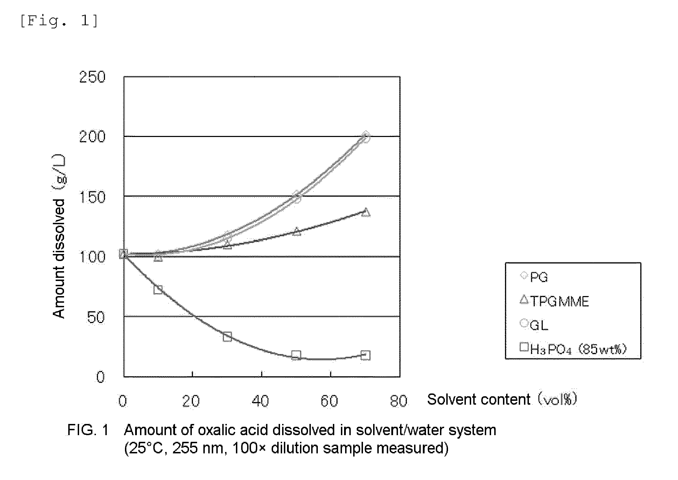

The amount of oxalic acid dissolved in each solution when the ratio by volume of organic solvent and water was changed is shown in FIG. 1. In the figure, PG denotes propylene glycol, TPGMME denotes tripropylene glycol monomethyl ether, and GL denotes glycerol.
These results confirm that, unlike H₃PO₄, which is an inorganic acid having a hydroxy group in the structure, an organic solvent that has a hydroxy group in the structure, has a vapor pressure of no greater than 17 mmHg, and is miscible with water, such as PG, TPGMME, or GL, has an effect in improving the solubility of oxalic acid accompanying an increase in the content.

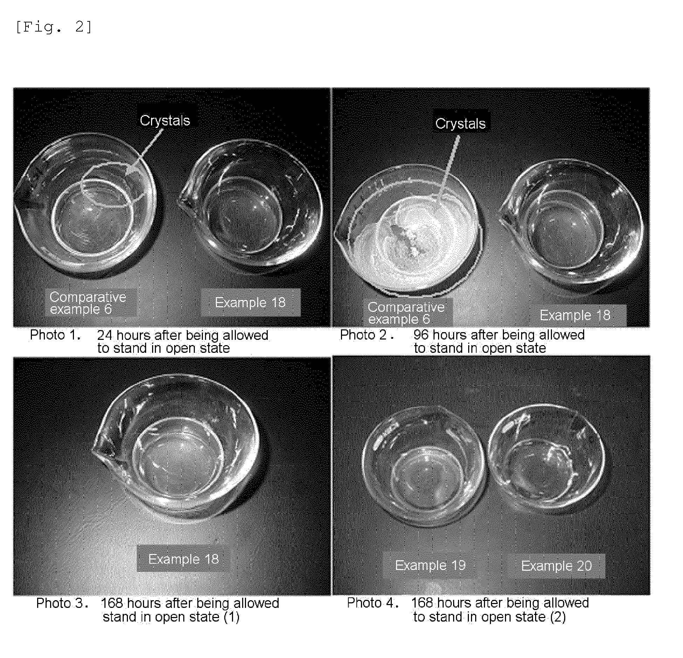

<Evaluation 2: Ascertainment of crystallization of aliphatic polycarboxylic acid when allowed to stand in open state>
Aliphatic polycarboxylic acid solutions (aliphatic polycarboxylic acid content 3.4 mass%) were prepared using a mixed solvent of propylene glycol and water (propylene glycol/water = 50/50 (ratio by volume)) and water as solvent. Each solution (10 mL) was placed in a watch glass and allowed to stand in an open state. Subsequently, the presence or absence of the precipitation of crystals was visually checked at predetermined time intervals. Table 2 and FIG. 2 show the state of each solution after being allowed to stand in an open state.

[Table 2]

**Table 2. State of each solution after being allowed to stand in open state**

| | Aliphatic polycarboxylic acid | Solvent | Appearance | | |
|---|---|---|---|---|---|
| | (3.4 g/100 mL) | (ratio by volume) | After 24 hr. | After 96 hr. | After 168 hr. |
| Ex. 18 | Oxalic acid | Propylene glycol/water = 50/50 | No change | No change | No change |
| Ex. 19 | Succinic acid | Propylene glycol/water = 50/50 | No change | No change | No change |
| Ex. 20 | Tartaric acid | Propylene glycol/Mater = 50/50 | No change | No change | No change |
| Comp. Ex. 6 | Oxalic acid | water = 100 | Crystal precipitation | Crystal precipitation. Solution dried to a solid | - |

The oxalic acid solution (Comparative Example 6) using water as the solvent already exhibited precipitation of crystals after being allowed to stand for 24 hours in an open state and dried to a solid after being allowed to stand for 96 hours in an open state, whereas the aliphatic polycarboxylic acid solutions (Examples 18 to 20) using a mixture of propylene glycol and water as the solvent did not exhibit precipitation of crystals even after being allowed to stand for 168 hours in an open state. These results confirm that a mixed solvent of an organic solvent and water does not evaporate when allowed to stand in a state open to the atmosphere and can suppress crystallization of an aliphatic polycarboxylic acid.

### <Evaluation 3: Ascertainment of residue removability using patterned wafer>

Patterned wafers for evaluation were prepared using the following method.
Copper damascene wiring using TiN/Ti as a barrier metal, an interlayer insulating film material (SiOC-based low-k film), SiO₂ for a hard mask, etc. were formed on a silicon wafer in sequence. Subsequently, the SiO₂ for a hard mask was processed by dry etching using as a mask a resist that had been applied to the SiO₂, exposed to light, and developed. Subsequently, the resist was removed by ashing, and the interlayer insulating film material was then processed by dry etching using the SiO₂ as a mask to thus form a via hole, thereby giving a wafer having photoresist residue and polymer residue attached thereto.

A wafer was immersed in each remover composition at 25°C for 10 min., rinsed in running water using ultrapure water, dried, and then examined using an electron microscope in terms of removability of photoresist residue and polymer residue and corrosivity toward copper and interlayer insulating film material. The results are shown in Table 3. In the table, tert-BuOH denotes 2-methyl-2-propanol, EG denotes ethylene glycol, PG denotes propylene glycol, 1,3-PD denotes 1,3-propanediol, 1,4-BD denotes 1,4-butanediol, GL denotes glycerol, DPG denotes dipropylene glycol, DPGMME denotes dipropylene glycol monomethyl ether, TPGMME denotes tripropylene glycol monomethyl ether, and THFA denotes tetrahydrofurfuryl alcohol.

As is clear from Table 3, it has been confirmed that, since the solution of oxalic acid in water has high solubility for copper oxide, which is a main component of residue, it has good residue removability; even when an organic solvent is combined therewith, substantially the same level of residue removability is exhibited, and the corrosivity toward copper or an interlayer insulating film is suppressed.

[Table 3]

**Table 3. Components of each composition**

| | Remover composition | | | | | | | | | Evaluation Results (25°C, 10min.) | | |
|---|---|---|---|---|---|---|---|---|---|---|---|---|
| | Aliphatic polycarboxylic acid | | | Organic solvent | | | Water | | Organic solvent/wat er | Residue removabilit y*¹ | Susceptibility to attack*² | |
| | (mol/L) | (mol/L) | (wt%) | | (mol/L) | (wt%) | (mol/L) | (wt%) | (ratio by volume) | | Copper | Interlayer insulating film |
| Ex. 21 | Oxalic acid | 0.38 | 3.81 | tert-BuOH | 5.31 | 44.03 | 23.11 | 52.17 | 50/50 | Good | Exc. | Exc. |
| Ex. 22 | Oxalic acid | 0.38 | 3.22 | EG | 8.99 | 52.83 | 27.18 | 43.95 | 50/50 | Exc. | Exc. | Exc. |
| Ex. 23 | Oxalic acid | 0.38 | 3.12 | PG | 6.82 | 47.58 | 32.57 | 49.30 | 50/50 | Exc. | Exc. | Exc. |
| Ex. 24 | Oxalic acid | 0.38 | 3.12 | PG | 9.55 | 66.60 | 20.00 | 30.28 | 70/30 | Exc. | Exc. | Exc. |
| Ex. 25 | Oxalic acid | 0.38 | 3.34 | 1,3-PD | 6.94 | 51.78 | 25.86 | 44.88 | 50/50 | Exc. | Exc. | Exc. |
| Ex. 26 | Oxalic acid | 0.38 | 3.39 | 1,4-BD | 5.58 | 50.14 | 25.92 | 46.47 | 50/50 | Exc. | Exc. | Exc. |
| Ex. 27 | Oxalic acid | 0.38 | 3.01 | GL | 6.85 | 55.78 | 29.24 | 41.21 | 50/50 | Exc. | Exc. | Exc. |
| Ex. 28 | Oxalic acid | 0.38 | 3.36 | DPG | 3.82 | 50.62 | 26.19 | 46.03 | 50/50 | Exc. | Exc. | Exc. |
| Ex. 29 | Oxalic acid | 0.38 | 3.49 | DPGMME | 3.21 | 48.72 | 25.21 | 47.80 | 50/50 | Good | Exc. | Exc. |
| Ex. 30 | Oxalic acid | 0.38 | 3.46 | TPGMME | 2.35 | 49.18 | 25.45 | 41.36 | 50/50 | Good | Exc. | Exc. |
| Ex. 31 | Oxalic acid | 0.38 | 3.31 | THFA | 5.15 | 51.27 | 26.54 | 45.41 | 50/50 | Exc. | Exc. | Exc. |
| Ex. 32 | Oxalic acid | 0.50 | 4.13 | PG | 6.82 | 47.58 | 31.90 | 48.30 | 50/50 | Exc. | Exc. | Exc. |
| Ex. 33 | Succinic acid | 0.38 | 4.09 | PG | 6.82 | 47.58 | 31.93 | 48.33 | 50/50 | Good | Exc. | Exc. |
| Ex. 34 | Malonic acid | 0.38 | 3.60 | PG | 6.82 | 47.58 | 32.25 | 48.82 | 50/50 | Good | Exc. | Exc. |
| Comp. Ex. 7 | Oxalic acid | 0.38 | 3.40 | | - | | 53.61 | 96.60 | 0/100 | Exc. | Exc. | Exc. |

| | | | | | | | | | | | | |
|---|---|---|---|---|---|---|---|---|---|---|---|---|
| *1: Exc.: excellent, Good: good, Fair: residue present in parts, Poor: could not be removed *2: Exc.; excellent, Good: hardly any corrosion, Fair: slight corrosion, Poor: some corrosion | | | | | | | | | | | | |

### [Industrial Applicability]

The photoresist residue and polymer residue remover composition of the present invention can provide a photoresist residue and polymer residue remover composition that can inhibit recrystallization of an aliphatic polycarboxylic acid due to evaporation of water after a solution has become attached to a liquid discharge nozzle, a cleaning bath, or the area around a chamber of a cleaning system that, using a single wafer cleaning system, which necessarily requires low temperature and a short processing time, can remove photoresist residue and polymer residue formed by ashing of a photoresist after processing by dry etching in a production process for a semiconductor circuit element having metal wiring, and can also provide a method for removing residue employing same.

## Claims

1. A composition for removing photoresist and/or polymer residue by single wafer cleaning, the composition comprising an aliphatic polycarboxylic acid having a melting point of at least 25°C and an organic solvent having a hydroxy group and a vapor pressure at 20°C of no greater than 17 mmHg.

2. The composition according to Claim 1, wherein it comprises water.

3. The composition according to Claim 1 or 2, wherein the organic solvent is one or more types selected from the group consisting of a monohydric to trihydric aliphatic alcohol, a compound in which one or two hydroxy groups of glycerol are replaced by an alkoxy group, a tetrahydrofurfuryl alcohol, a monoalkylene glycol monoalkyl ether, a polyalkylene glycol, and a polyalkylene glycol monoalkyl ether.

4. The composition according to any one of Claims 1 to 3, wherein the organic solvent is miscible with water.

5. The composition according to any one of Claims 1 to 4, wherein the content of the organic solvent is at least 30 vol%.

6. The composition according to any one of Claims 1 to 5, wherein the aliphatic polycarboxylic acid is oxalic acid.

7. A method for removing photoresist and/or polymer residue by single wafer cleaning by use of the composition according to any one of Claims 1 to 6.
